# EUROPEAN PATENT SPECIFICATION

(11) **EP 3 766 106 B1**
(45) Date of publication and mention of the grant of the patent: **05.01.2022**
(21) Application number: 19708874.3
(22) Date of filing: 12.03.2019
(51) Int. Cl.: H01L 33/60, C08L 27/18, C08K 3/22, C08K 3/30, H01L 33/50

(54) **FLUOROPOLYMER COMPOSITION FOR COMPONENTS OF LIGHT EMITTING APPARATUS**
FLUORPOLYMERZUSAMMENSETZUNG FÜR KOMPONENTEN EINER LICHTEMITTIERENDEN VORRICHTUNG
COMPOSITION DE FLUOROPOLYMÈRE POUR COMPOSANTS D'APPAREIL ÉLECTROLUMINESCENT

(30) Priority: 15.03.2018 EP 18162112
(43) Date of publication of application: 20.01.2021
(73) Proprietor: Solvay Specialty Polymers Italy S.p.A., 20021 Bollate (MI) (IT)
(72) Inventor: COLAIANNA, Pasqua, 20100 Milano (IT); BESANA, Giambattista, 22066 Mariano Comense (IT); CANIL, Giorgio, 20900 Monza (IT); AVATANEO, Marco, 20135 Milano (IT)
(74) Representative: Benvenuti, Federica
(86) International application number: PCT/EP2019/056196
(87) International publication number: WO 2019/175197

(56) References cited:
- EP-A1- 3 088 460
- WO-A1-2011/068835
- WO-A1-2015/112751
- WO-A2-2009/026284
- WO-A2-2010/019459

## Description

### Technical Field

The invention pertains to a fluoropolymer composition comprising certain thermoprocessable tetrafluoroethylene copolymers, certain amounts of specific PTFE micropowders and a white pigment, to the use of this latter for manufacturing shaped articles, and to shaped articles therefrom, including components of light emitting apparatuses, e.g. LED assemblies.

### Background Art

Light emitting diode (LED) components, such as housings, reflectors, reflector cups, heatsink slugs, require an especially demanding combination of excellent colour and improved physical properties, so as to ensure good opacity and outstanding reflective properties both after high temperature processing and soldering conditions (during LED assembly manufacture) and after prolonged exposure to heat and radiation, such as those of continuous LED operations. This is particularly true for LED assemblies of new generations, adapted to higher conductive power dissipations, necessitating, notably, the use of a central heat-conducting slug in packages. While ceramics might be used for manufacturing above mentioned components, their inherent cost and highly demanding processing technologies have called for alternative materials. Therefore, plastics have been extensively studied and developed to this aim.

Light-emitting diode (LED) housings are conventionally constructed from engineering plastics such as semi-aromatic polyphthalamides (PPA) to which titanium dioxide is added to increase the visible light reflectance of the housing and fillers are incorporated for improving mechanical performances and thermal resistance. However, PPA are known to be possibly susceptible to discoloring (yellowing) phenomena with use over time, resulting in overall LED efficiency drop and change in emitted color.

Fluoromaterial-based compounds have hence been proposed in this field of use, leveraging on improved thermal stability/chemical inertness of fluoromaterials over notably polyamide structures.

Hence, US 2010032702 (DUPONT) 11/02/2010 discloses a light-emitting diode housing comprising a fluoropolymer and a white pigment. Fluoropolymer of utility in the LED housing provided in this document are melt extrudable and injection moldable, and have a melt flow rate of about 1.5 to about 40 g/10 min and include, *inter alia,* perfluoroalkoxy fluorocarbon resin (PFA), the copolymer of tetrafluoroethylene and perfluoro(alkyl vinyl ether), sold under the trademark TEFLON^{®} PFA by DuPont, TFE/PAVE fluoropolymers, commonly known as PFA, having at least about 2 weight percent PAVE of the total weight per cent, including when the PAVE is PPVE or PEVE, and typically contain about 2 to about 15 weight percent PAVE, and TFE/PAVE fluoropolymers, commonly known as MFA, when the PAVE includes PMVE, and the composition is about 0.5 to about 13 weight percent perfluoro(methyl vinyl ether), and about 0.5 to about 3 weight percent PPVE, the remainder of the total of 100 weight percent being TFE.

JP 2011195710 (SUMITOMO ELECTRIC INDUSTRIES) 6/10/2011 discloses a white resin molded product which has, as a material constituting the reflector part of LED, suitable properties such as high resistance to deterioration by heat and resistance to deterioration by light having difficulty in discoloration even when exposed to a high-temperature environment of not lower than 150°C and light for a long time, furthermore ease of fabrication, and an LED reflector composed of this white resin molded product. The white resin molded product is obtained by molding a resin composition composed of a fluororesin (A) having a melting point of not lower than 260°C and titanium oxide (B), and the LED reflector is composed of this white resin molded product. Working embodiment's comprise an exemplary molding composition made from HYFLON^{®} MFA 1041 tetrafluoroethylene/perfluoromethylvinylether copolymer, which is known to possess a melt flow rate of about 25-26 g/10 min (372°C/5 kg).

Still, US 2014063819 (MITSUI DU PONT FLUORCHEMICAL ) 6/03/2014 discloses a reflector for a light-emitting diode which has a small decrease in reflectance in a range from the ultraviolet region to visible region, and has excellent heat resistance, light resistance, and weather resistance, and a housing having this reflector. This reflector is obtained by molding a fluororesin composition containing a filler with an average particle diameter of smaller than 1 µm, wherein the difference between the maximum value and the minimum value of the reflectance at a wavelength of 240-700 nm is within 25%. The fluororesin is preferably selected among TFE copolymers such as FEP (TFE/HFP copolymer), PFA (TFE/PAVE copolymer), TFE/HFP/PAVE copolymer, where PAVE is perfluoro(ethylvinyl ether) (PEVE) and/or perfluoro(propylvinyl ether) (PPVE), MFA (TFE/perfluoro(methyvinyl ether) (PMVE)/PAVE copolymer, where the alkyl group of PAVE has 2 or more carbon atoms), THV (TFE/HFP/vinylidene fluoride (VF2) copolymer), etc. The TFE copolymer has a melt flow rate (MFR) of about 0.5-100 g/10 min, preferably 0.5-50 g/10 min, which is measured at a standard temperature of said specific TFE copolymer according to ASTM D-1238.

Yet, WO 2017/148905 (SOLVAY SPECIALTY POLYMERS IT) 8/09/2017 pertains to a fluoropolymer composition comprising certain tetrafluoroethylene/perfluoromethyvinylether copolymers having well-defined TFE/MVE monomer composition and possessing low molecular weight and a white pigment, to the use of this latter for manufacturing shaped articles, and to shaped articles therefrom, including components of light emitting apparatuses, e.g. LED assemblies.

Nevertheless, there is a continuous need for polymer compositions suitable to be used for manufacturing injection molded parts, in particular LED components, possessing improved performances, including, notably, higher reflectance of light (both in the visible and in the UV spectral regions), higher whiteness, and improved processability (e.g. expressed by lowered melt flow rates) enabling good moldability in replicating miniaturized patterns.

WO 2015/112751 is directed to a fluoroelastomer composition including certain tetrafluoroethylene copolymers including cure-sites, one of which is conveyed under the form of particles, which may comprise additional fillers, among which is mention made of barium sulfate and titanium oxide).

WO 2011/068835 is directed to a fluororubber component of a fuel management system, said fluororubber component including a cured fluoroealstomer and a non-fibrillating PTFE micropowder. The fluororubber maybe a TFE-based fluororubber.

WO2010/019459 is directed to a light-emitting diode housing made from a fluoropolymer composition, which may comprise PFA or FEP, and which, according to certain embodiments, includes filler, which maybe titanium dioxide, for increasing photopic reflectance, and which may include organic fillers, such as, among others, PTFE microparticles.

WO09026284 is directed to a solvent-based coating composition including a soluble fluoropolymer and a particulate insoluble fluoropolymer; according to certain embodiments, both fluoropolymers may be tetrafluoroethylene-hexafluoropropylene-vinylidene fluoride (THV)-type polymers, but differing because of their monomer composition; according to other embodiments, the particulate insoluble fluoropolymer may be a PTFE micropowder. The composition may comprise additional additives, such as notably colouring agents and/or whitening agents, and is particularly suitable for forming a coated layer, e.g. on a LED device, acting as a sealant.

### Summary of invention

The Applicant has now found that the combinations of certain thermoprocessable tetrafluoroethylene copolymers and certain amounts of specific PTFE micropowders are particularly advantageous when compounded with specific ingredients (white pigments) to provide polymer compounds particularly effective in fulfilling above mentioned requirements, and hence delivering LED parts fulfilling all aforementioned requirements.

The invention further pertains to a fluoropolymer composition [composition (C)] comprising:
(i) at least 50% by weight, with respect to the total weight of the composition (C) of at least one melt-processible perfluorinated tetrafluoroethylene copolymer [polymer (F)],
(ii) from 1 to less than 50 % wt., with respect to the total weight of the composition (C) of at least one pigment selected from the group consisting of titanium dioxide (TiO₂), zinc disulfide (ZnS₂), zinc oxide (ZnO) and barium sulfate (BaSO₄) [pigment (P)];
(iii) from 0.5 to 20 % wt., with respect to the total weight of the composition (C) of at least one PTFE micropowder possessing a B.E.T. surface area of exceeding 5.0 m²/g [powder (PTFE)]; and optionally,
(iii) at least one reinforcing filler [filler (F)], different from pigment (P).

The Applicant has surprisingly found that the composition (C), thanks to the presence of said combination of thermoprocessable tetrafluoroethylene copolymers and certain amounts of specific PTFE micropowders, when combined with the mentioned white pigment and possibly other ingredients, can be injection molded for providing parts possessing outstanding light reflectance capabilities and possessing improved processability, including the possibility of being processed in relatively smooth conditions (moderated temperatures and pressured), as well as all other desirable properties typical of fluoropolymer compositions, so as to establish as material of choice for the manufacture of components for LED, in particular reflectors.

### Brief description of drawings

Figure 1 is a top view LED comprising one or more component made from the composition of the invention.
Figure 2 is a power LED comprising one or more component made from the composition of the invention.

### Description of embodiments

The composition (C) may comprise one or more than one melt processable tetrafluoroethylene copolymer, as above detailed, more particularly of a polymer formed of tetrafluoroethylene (TFE) copolymer with one or more perfluorinated comonomers [comonomer (F)]. For the purpose of the present invention, a "melt-processible" polymer refers to a polymer that can be processed (i.e. fabricated into shaped articles of whichever shape) by conventional melt extruding, molding, injecting or coating means. This generally requires that the melt viscosity of the polymer at the processing temperature be no more than 10⁸ Pa × sec, preferably from 10 to 10⁶ Pa × sec.

Preferably, the polymer (F) of the present invention is semi-crystalline. For the purpose of the present invention, the term "semi-crystalline" is intended to denote a polymer having a heat of fusion of more than 1 J/g when measured by Differential Scanning Calorimetry (DSC) at a heating rate of 10°C/min, according to ASTM D 3418. Preferably, the semi-crystalline polymer (F) of the invention has a heat of fusion of at least 15 J/g, more preferably of at least 25 J/g, most preferably at least 35 J/g.

The polymer (F) comprises advantageously more than 0.5 % wt, preferably more than 2.0 % wt, and more preferably at least 2.5 % wt of comonomer (F).

The polymer (F) as above detailed comprises advantageously at most 20 % wt, preferably at most 15 % wt, and more preferably 10 % wt of comonomer (F).

Good results have been obtained with the polymer (F) comprising at least 0.7% wt and at most 10% wt of comonomer (F).

Among suitable comonomers (F), mentions can be made of:
- C₃-C₈ perfluoroolefins, e.g. hexafluoropropene (HFP), hexafluoroisobute-ne;
- CF₂=CFOR_{f} perfluoroalkylvinylethers (PAVE), wherein R_{f} is a C₁-C₆ perfluoroalkyl, e.g., -CF₃, -C₂F₅, or -C₃F₇;
- CF₂=CFOX perfluorooxyalkylvinylethers wherein X is a C₁-C₁₂ perfluorooxyalkyl having one or more ether groups; and
- perfluorodioxoles.

Preferably, said comonomer (F) is selected from the following comonomers:
- PAVEs of formula CF₂=CFOR_{f1}, wherein R_{f1} is selected from -CF₃, -C₂F₅, and -C₃F₇, namely,
   perfluoromethylvinylether (PMVE of formula CF₂=CFOCF₃), perfluoroethylvinylether (PEVE of formula CF₂=CFOC₂F₅ ), perfluoropropylvinylether (PPVE of formula CF₂=CFOC₃F₇), and mixtures thereof;
- perfluoromethoxy vinyl ether (MOVE) of general formula CF₂=CFOC-F₂OR_{f2}, wherein R_{f2} is a linear or branched C₁-C₆ perfluoroalkyl group, cyclic C₅-C₆ perfluoroalkyl group, a linear or branched C₂-C₆ perfluoroxyalkyl group; preferably, R_{f2} is -CF₂CF₃ (MOVE1), -CF₂CF₂OCF₃ (MOVE2), or -CF₃ (MOVE3); and
- perfluorodioxoles having the following formula: 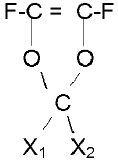
wherein X₁ and X₂, equal to or different from each other, are selected between F and CF₃, preferably F.

According to a first embodiment of the invention, the polymer (F) is selected from the group consisting of TFE copolymers comprising recurring units derived from hexafluoropropylene (HFP) and from at least one perfluoroalkylvinylether, as above defined.

Preferred polymers (F) according to this embodiment are selected among TFE copolymers comprising (preferably consisting essentially of) recurring units derived from tetrafluoroethylene (TFE) and hexafluoropropylene (HFP) in an amount ranging from 3 to 15 wt % and from 0.5 to 3 wt % of at least one perfluoroalkylvinylether, as above defined.

The expression 'consisting essentially of' is used within the context of the present invention for defining constituents of a polymer to take into account end chains, defects, irregularities and monomer rearrangements which might be comprised in said polymers in minor amounts, without this modifying essential properties of the polymer.

A description of such polymers (F) can be found notably in US 4029868 (DUPONT) 14/06/1977 , in US 5677404 (DUPONT) 14/10/1997 , in US 5703185 (DUPONT) 30/12/1997 , and in US 5688885 (DUPONT) 18/11/1997 .

Polymers (F) according to this embodiment are commercially available under the trademark TEFLON^{®} FEP 9494, 6100 and 5100 from E.I. DuPont de Nemours, or from Daikin (e.g. FEP NP-101 material), or from Dyneon LLC (FEP 6322).

Best results within this embodiment have been obtained with TFE copolymers comprising (preferably consisting essentially of) recurring units derived from tetrafluoroethylene (TFE) and hexafluoropropylene (HFP) in an amount ranging from 4 to 12 wt % and either perfluoro(ethyl vinyl ether) or perfluoro(propyl vinyl ether) in an amount from 0.5 to 3 % wt.

According to a second embodiment of the invention, the polymer (F) is selected from the group consisting of TFE copolymers comprising recurring units derived from at least one perfluoroalkylvinylether, as above defined and optionally further comprising recurring units derived from at least one C₃-C₈ perfluoroolefin, as detailed above.

Good results within this second embodiment have been obtained with TFE copolymers comprising recurring units derived from one or more than one perfluoroalkylvinylether as above specified; particularly good results have been achieved with TFE copolymers wherein the perfluoroalkylvinylether is selected from the group consisting of PMVE, PEVE, PPVE and mixtures thereof.

According to a preferred variant of the second embodiment of the invention, the polymer (F) is advantageously a TFE/PMVE copolymer consisting essentially of :
(a) from 3 to 13 %, preferably from 5 to 12 % by weight of recurring units derived from perfluoromethylvinylether;
(b) from 0 to 6 % by weight of recurring units derived from one or more than one fluorinated comonomer different from perfluoromethylvinylether and selected from the group consisting of perfluoroalkylvinylethers as detailed above, and perfluorooxyalkylvinylethers as detailed above; preferably derived from perfluoroethylvinylether and/or perfluoropropylvinylether ;
(c) recurring units derived from tetrafluoroethylene, in such an amount that the sum of the percentages of the recurring units (a), (b) and (c) is equal to 100 % by weight.

The said TFE/PMVE copolymer generally possesses a melting point, determined according to ASTM D3418 of at least 265°C, preferably at least 270°C, and generally at most 290°C, preferably at most 285°C.

As said, the said TFE/PMVE copolymer possesses a MFR of more than 5 g/10 min, when determined at 372°C under a piston load of 5 kg. Upper boundaries for the MFR are not particularly critical. Nevertheless, it is generally preferred to use in the composition (C) a TFE/PMVE copolymer having a MFR of less than 800 g/10 min, advantageously of less than 700 g/10 min, preferably less than 600 g/10 min, more preferably less than 550 g/10 min, measured as above detailed, to the sake of optimizing processability without detrimentally affecting mechanical properties.

The TFE/PMVE copolymer of this variant is most preferably a copolymer preferably essentially consists of:
- from 3.7 to 5.8 % moles of recurring units derived from perfluoromethylvinylether (PMVE);
- from 94.2 to 96.3 % moles of recurring units derived from tetrafluoroethylene (TFE).

According to another preferred variant of this second embodiment of the invention, the polymer (F) is advantageously a TFE copolymer consisting essentially of :
(a) from 0.5 to 5 % by weight of recurring units derived from perfluoromethylvinylether;
(b) from 0.4 to 4.5 % by weight of recurring units derived from one or more than one fluorinated comonomer different from perfluoromethylvinylether and selected from the group consisting of perfluoroalkylvinylethers, as above detailed and perfluorooxyalkylvinylethers, as above detailed; preferably derived from perfluoroethylvinylether and/or perfluoropropylvinylether ;
(c) from 0 to 6 % weight of recurring units derived from at least one C₃-C₈ perfluoroolefins, preferably derived from hexafluoropropylene; and
(d) recurring units derived from tetrafluoroethylene, in such an amount that the sum of the percentages of the recurring units (a), (b), (c) and (d) is equal to 100 % by weight.

According to yet another variant of this second embodiment, polymer (F) is advantageously a TFE copolymer consisting essentially of:
(a) from 0.5 to 8 %, preferably from 0.7 to 6 % by weight of recurring units derived from PPVE;
(b) recurring units derived from TFE, in such an amount that the sum of the percentages of the recurring units (a) and (b) is equal to 100 % by weight.

MFA and PFA suitable to be used for the composition of the invention are commercially available from Solvay Specialty Polymers Italy S.p.A. under the trade name of HYFLON^{®} PFA P and M series and HYFLON^{®} MFA and HYFLON^{®} F.

As said, the polymer (F) is the major constituent of the composition (C). The weight percent of the polymer (F) in the composition (C) is generally of at least 50 wt. %, preferably of at least 55 wt. %, and more preferably of at least 60 wt. %, based on the total weight of the composition (C). It is further understood that the weight percent of the polymer (F) in the composition (C) will generally be of at most 95 wt. %, preferably of at most 85 wt. % and most preferably of at most 80 wt. %, based on the total weight of the composition (C).

Excellent results were obtained when the composition (C) comprised the polymer (F) in an amount of 65-95 wt. %, preferably of 70-93 wt. %, more preferably 75-92 wt. %, based on the total weight of the composition (C).

Reinforcing fillers [fillers (F)] which are suitable to be possibly used in the composition (C) of the invention are well known by the skilled in the art.

Having regards to its morphology, the filler (F) of the composition (C) can be generally selected from the group consisting of fibrous fillers and particulate fillers.

Typically, the filler (F) is selected from the group consisting of mineral fillers (such as talc, mica, kaolin, calcium carbonate, calcium silicate, magnesium carbonate), glass fiber, carbon fibers, synthetic polymeric fiber, aramid fiber, aluminum fiber, titanium fiber, magnesium fiber, boron carbide fibers, rock wool fiber, steel fiber, wollastonite, inorganic whiskers. Still more preferably, it is selected from mica, kaolin, calcium silicate, magnesium carbonate, inorganic whiskers, glass fiber and wollastonite.

A particular class of fibrous fillers which are advantageously usable in the composition (C) consists of whiskers, i.e. single crystal fibers made from various raw materials, such as Al₂O₃, SiC, BC, Fe and Ni.

According to certain embodiments, the filler (F) can be selected from the group consisting of fibrous fillers. Among fibrous fillers, glass fibers are preferred; non limitative examples of glass fibers include notably chopped strand A-, E-, C-, D-, S- and R-glass fibers, as described in chapter 5.2.3, p. 43-48 of Additives for Plastics Handbook, 2nd edition, John Murphy, the whole content of which is herein incorporated by reference. Glass fibers fillers useful in composition (C) may have a round cross-section or a non-circular cross-section.

In certain embodiment's of the present invention, the filler (F) is selected from the group consisting of wollastonite fillers and glass fiber fillers.

When present, the weight percent of the filler (F) in the composition (C) is generally of at least 0.1 wt. %, preferably of at least 0.5 wt. %, more preferably of at least 1 wt. % and most preferably of at least 2 wt. %, based on the total weight of composition (C). The weight percent of the filler (F) is generally of at most 30 wt. %, preferably of at most 20 wt. % and most preferably of at most 15 wt. %, based on the total weight of the composition (C).

Nevertheless, preferred compositions (C) are those wherein no additional filler (F) is added to the combination of polymer (F), powder (PTFE) and pigment (P).

Above mentioned pigments (P) are typically known as white pigments, in that they absorb limited incident visible radiation and scatter most of said incident visible radiation. Otherwise stated, the pigments (P) used in the composition (C) generally absorb essentially no light in the visible region (wavelength 400 - 800 nm), and in certain cases some of them generally absorb no light in th UV region (wavelength 100-400 nm), but they disperse incident radiation in this region as completely as possible.

The pigment (P) is selected from the group consisting of titanium dioxide (TiO₂), zinc disulfide (ZnS₂), zinc oxide (ZnO) and barium sulfate (BaSO₄).

According to certain embodiments, the pigment (P) may be titanium dioxide. Suitable titanium dioxide pigments can be supplied from a variety of commercial sources, including notably Chemours, ISK. The nature of the titanium dioxide pigment is not particularly limited, and a variety of crystalline forms such as the anatase form, the rutile form and the monoclinic type can be advantageously used. However, the rutile form is generally preferred due its higher refraction index and its superior light stability. Titanium dioxide pigment may be treated on its surface with at least one treatment agent, even if embodiments wherein titanium dioxide pigments have no surface treatment are also suitable. Preferably the APS of the titanium dioxide pigment is in the range of 0.05 µm to 0.40 µm.

Barium sulfate (BaSO₄) is particularly preferred when the composition is intended for use in UV LED, with emitting wavelengths between 100-410 nm, whereas TiO₂ cannot be used, because of its absorption. Hence, in preferred composition intended for UV-LED devices, the pigment (P) is preferably BaSO₄.

When using BaSO₄ as pigment (P), at least one of the following pre-treatment may be applied to commercially sourced BaSO₄, before incorporation into the composition (C) of the present invention:
- washing/rinsing with water, for removal of water-soluble contaminants; and
- thermal pre-treatment, e.g. at temperatures of 80°C or beyond, for instance, under vacuum or in air or under inert gas (e.g. N₂), generally for a suitable time enabling advantageously extensive moisture or contaminants removal.

The pigment (P) is advantageously present in the composition (C) under the form of particles having an average particle size (APS, expressed as D₅₀) of generally less than 250 µm, preferably less than 100 µm, more preferably of less than 5 µm. Larger sizes may deleteriously affect the properties of the composition.

While pigments (P) having larger APS can be used, these pigments (P) are less advantageous, in that they might impair other relevant properties (e.g. mechanical properties) of the composition (C).

Preferably, the APS of the pigment (P) is of below 5 µm. While lower boundaries for APS of pigment (P) are not particularly critical, it is generally understood that pigment (P) will have an APS of at least 0.1 µm.

Average particle size of pigment (P) is generally determined by laser diffraction method, where the average size is determined as D₅₀, i.e. is the diameter of the particle that 50% of a sample's mass is smaller than and 50% of a sample's mass is larger than.

The shape of the particles of pigment (P) is not particularly limited; the said particles may be notably round, flaky, flat and so on.

The weight percent of the pigment (P) in the composition (C) is generally of at least 1 wt. %, preferably of at least 3 wt. %, more preferably of at least 5 wt. % and most preferably of at least 6 wt. %, based on the total weight of the composition (C). Besides, the weight percent of the pigment (P) is generally of less than 50 wt. %, preferably of at most 45 wt. %, more preferably of at most 30 wt. %, even more preferably of at most 25 wt. % and most preferably of at most 20 wt. %, based on the total weight of the composition (C).

Excellent results were obtained when the pigment (P) was used in an amount of 3-35 wt. %, preferably of 5-25 wt. %, based on the total weight of the composition (C).

PTFE micropowders are well known in the art, and are low molecular weight derivatives of non-melt flowable PTFE polymers, which may be obtained by direct polymerization under conditions that prevent very long polymer chains from forming, or by irradiation degradation of non-melt flowable PTFE polymers. Generally, nevertheless, PTFE micropowders are resulting from irradiation degradation of non-melt flowable PTFE polymers.

As mentioned above, it is essential for the powder (PTFE) to possess a B.E.T. surface area of exceeding 5.0 m²/g, preferably of exceeding 6.0 m² /g, more preferably of exceeding 7.0 m²/g.

B.E.T. surface area determination is carried out measuring the volume of nitrogen adsorbed to the surface of the particles at the boiling point of nitrogen (-196°C). The amount of adsorbed nitrogen is correlated to the total surface area of the particles including pores in the surface based on the BET (Brunauer, Emmett and Teller) theory.

Generally, such high B.E.T. surface area is also accompanied in powder (PTFE) by a bulk density of less than 380, preferably less than 350, more preferably less than 340 g/l, whereas bulk density is measured according to ASTM D 4895 standard, referring back to ASTM D1895.

From a compositional standpoint, the PTFE micropowder may be a homopolymer of TFE or a copolymer thereof with at least one other fluorine-containing monomer in an amount of not larger than 1% by weight. Such copolymers are known as "modified PTFEs" and is distinguished from a melt processable TFE copolymer. As the modifier, copolymerizable monomers including per(halo)fluoroolefins different from TFE, e.g. tetrafluoroethylene, chlorotrifluoroethylene, perfluoroalkylvinylethers, perfluorodioxoles have been used for manufacturing modified PTFE. In general, nevertheless, powder (PTFE) are homopolymers of TFE.

The powder (PTFE) can also be characterized by high crystallinity, preferably exhibiting a heat of crystallization of at least 50 J/g.

The powder (PTFE) is advantageously melt flowable. By 'melt flowable' it is meant that the PTFE has a non-zero melt flow rate that is measurable by ASTM D 1238, when measured at 372°C, under a piston load of 10 kg.

The powder (PTFE) has generally melt flowability such that its melt flow rate (MFR) is of at least 0.01 g/10 min, preferably at least 0.1 g/10 min and more preferably at least 0.5 g/10 min, as measured in accordance with ASTM D 1238, at 372°C, using a 10 kg weight on the molten polymer.

While the powder (PTFE) has low molecular weight, it nevertheless has sufficient molecular weight to be solid up to high temperatures, e.g. possessing a melting point of at least 300°C, more preferably at least 310° , even more preferably, at least 318°C. In a particularly preferred manner, melting point of powder (PTFE) is of at least 328°C, more preferably at least 329°C, when determined according to ASTM D 3418 standard.

The powder (PTFE) can be obtained from Solvay Specialty Polymers Italy S.p.A. under the trade name of Algoflon^{®} L.

The pigment (PTFE) is advantageously present in the composition (C) under the form of particles having an average particle size (APS, expressed as D₅₀, as detailed above) of generally less than 25 µm, preferably less than 15 µm, more preferably of less than 10 µm, most preferably of less than 7.5 µm. Larger sizes may deleteriously affect the properties of the composition.

Preferably, the APS (D₅₀) of pigment (PTFE) is of about 5 µm or below 5 µm. While lower boundaries for APS (D₅₀) of pigment (PTFE) are not particularly critical, it is generally understood that pigment (PTFE) will have an APS of at least 0.1 µm.

The weight percent of the powder (PTFE) in the composition (C) is generally of at least 1 wt. %, preferably of at least 3 wt. %, more preferably of at least 5 wt. %, based on the total weight of the composition (C). Besides, the weight percent of the powder (PTFE) is generally of at most 18 wt. %, preferably of at most 17 wt. %, more preferably of at most 16 wt. % and most preferably of at most 15 wt. %, based on the total weight of the composition (C).

### Optional ingredients

The composition (C) can optionally comprise additional components such as stabilizing additive, notably mould release agents, plasticizers, lubricants, thermal stabilizers, light stabilizers and antioxidants etc.

### The article

An aspect of the present invention also provides an article comprising at least one component comprising the fluoropolymer composition (C), as above detailed, which provides various advantages over prior art parts and articles, in particular an increased resistance to concurrent exposure to heat and radiation (both visible and UV) while maintaining all their other properties at a high level. Preferably, the article or part of the article consists of the composition (C) as above detailed.

In a particular embodiment, the article is a light emission apparatus.

Non limitative examples of light emission apparatuses are keyless entry systems of an automobile, lightings in a refrigerator, liquid crystal display apparatuses, automobile front panel lighting apparatuses, desk lamps, headlights, household electrical appliance indicators and outdoor display apparatuses such as traffic signs, and optoelectronic devices comprising at least one semi-conductor chip that emits and/or transmits electromagnetic radiation commonly known as Light Emitting Diodes devices (LEDs). Preferably, the light emission apparatus is a Light Emitting Diode device (LED).

Depending on the electroluminescence characteristic of the junction diode comprised in the LED device as emitting source, the LED of the invention may notably emit in the visible region or in the UV region.

LED devices emitting in the visible region typically possess one or more than one junctions emitting at different wavelength in the visible spectral region. Red LED junctions may emit between 620 and 645 nm; red-orange LED junctions may emit between 610 and 620 nm, green LED junction may emit between 520 and 550 nm, cyan LED junctions may emit between 490 and 520 nm, and blue LED junctions may emit between 460 and 490 nm. Any combination thereof may be used to provide for white light; as an alternative, phosphor(s) may be used in combination with single-color LED junctions to convert monochromatic light from a blue or UV LED to broad-spectrum white light, through Stokes shift of the phorphor(s) used.

LED devices possessing junctions emitting in the UV region may emit Ultraviolet A (or UVA) in the region of 315-400 nm in wavelength, Ultraviolet B (or UVB) in the region of 280-315 nm in wavelength, and Ultraviolet C (or UVC) in the region of 100-280 nm in wavelength.

LED devices emitting in the UV region are e.g. designed to be used for UV curing applications, for instance in digital print applications and inert UV curing environments, but also for other general purposes curing systems, e.g. in dental fields or even for nail polishes and lacquers; still, UV LEDs (in particular UV-C LEDs) are suitable to be used in disinfection (e.g. for air or aqueous media disinfection) and as line sources to replace deuterium lamps in liquid chromatography instruments; yet, UV-LED may be used as sensors/detectors, e.g. for counterfeit banknotes detection, for verifying identity documents/passports or for controlling other goods against counterfeit.

Structurally, LEDs are preferably chosen from the group of top view LEDs, side view LEDs and power LEDs. Top view and side view LEDs comprise usually a basic housing, which, in general, acts as reflector; besides, top view and side view LEDs usually do not comprise any heatsink slug. On the other hand, power LEDs comprise usually a heatsink slug, which, in general, acts as reflector; power LEDs usually further comprise a basic housing, which is a part distinct from the heatsink slug.

The top view LEDs are notably used in automotive lighting applications such as instrumental panel displays, stop lights and turn signals. The side view LEDs are notably used for mobile appliance applications such as, for example, cell phones and PDAs. The power LEDs are notably used in flashlights, automotive day light running lights, signs and as backlight for LCD displays and TVs.

The LED according to the present invention comprises at least one part comprising the composition (C) as above described. The part is preferably selected from the group consisting of basic housings and heatsink slugs. The part made from the composition (C), as above detailed, is generally intended to act as reflector in a LED device.

Preferably at least 50 wt. % and more preferably more than 80 wt. % of the part comprises the composition (C), being understood that the part may possibly further contain other materials, e.g. a metal; for example, for certain end uses, the surface of certain parts made from the composition (C), as above detailed, and acting as reflector, may be metal plated. More preferably, more than 90 wt. % of the part comprises the composition (C). Still more preferably, the part consists essentially of the composition (C). The most preferably, the part consists of the composition (C).

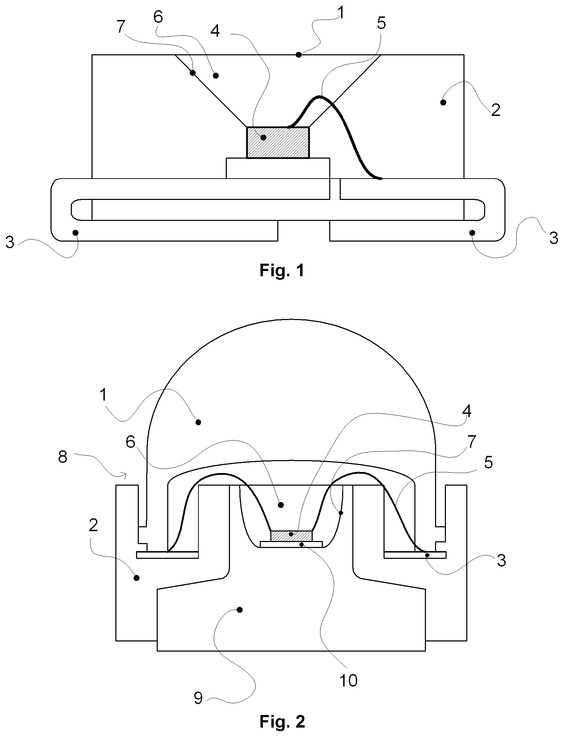

An exemplary embodiment of a top view LED is provided in Figure 1, which illustrates a sectional view of said embodiment. The top view LED 1 comprises a basic housing 2 comprising, and preferably consisting of, the composition (C) as above detailed. As will be detailed hereafter, the basic housing 2 acts also as reflector cup. No heatsink slug is present. Usually, the LED 1 further comprises a prefabricated electrical lead frame 3. Lead frame 3 can be advantageously encapsulated by injection moulding with the composition (C) included in the basic housing 2.

The basic housing 2 has a cavity 6. A semiconductor chip 4 that emits electromagnetic radiations, such as a LED chip, is mounted inside such cavity. The semiconductor chip 4 is generally bonded and electrically contact-connected on one of the lead frame terminals by means of a bonding wire 5.

A transparent or translucent potting compound (e.g. an epoxy, a polycarbonate or a silicone resin, not shown in Figure 1) is generally built into the cavity in order to protect the LED chip. It is customary, for the purpose of increasing the external efficiency of the LED chip, to shape the cavity of the basic housing with non-perpendicular inner areas in such a way that the cavity acquires a form opening towards the front side (the sectional view of the inner wall of the cavity may have, for instance, the form of an oblique straight line, as in the exemplary embodiment in accordance with Figure 1, or that of a parabola).

Thus, the inner walls 7 of the cavity serve as reflector cup for the radiation which is emitted laterally by the semiconductor chip or junction, notably reflecting this radiation towards the front side of the basic housing.

It is understood that the number of chips or junctions which can be mounted in the cavity of the basic housing, as well as the number of cavities which can be formed inside a basic housing, is not restricted to one.

An exemplary embodiment of a power LED is provided in Figure 2, which illustrates a sectional view of said embodiment. The power LED 8 comprises advantageously an aspherical lens 1 and a basic housing 2 comprising, and preferably consisting of, the composition (C), as above detailed. As in the previous embodiment, the LED 8 further comprises a prefabricated electrical lead frame 3.

The power LED 8 also comprises a carrier body or heatsink slug 9 which may comprise, or consist of, the composition (C) as above detailed. A cavity 6 is realized in the upper portion of the heatsink slug 9. A semiconductor LED chip or junction 4 that emits electromagnetic radiations is mounted on the bottom area of cavity 6 and it is generally fixed by means of a carrier substrate or solder connection 10 to the heatsink slug 9. The solder connection 10 is generally an epoxy resin or another equivalent adhesive material. The LED chip or junction is generally conductively connected to the electric terminals of the lead frame 3 via the bonding wires 5.

The inner walls 7 of the cavity 6 run generally from the bottom area of the cavity to the front side so as to form a reflector cup increasing the external efficiency of the LED chip. The inner walls 7 of the reflector cup may be, for example, straight and oblique or concavely curved (like in the exemplary embodiment in accordance with Figure 2).

The lead frame 3 and the heatsink slug 9 are generally encapsulated within the basic housing 2. In order to protect the LED chip or junction 4, the cavity is generally completely filled, likewise in the first exemplary embodiment of Figure 1, with a radiation- transmissive, for example transparent, encapsulation compound (the encapsulant is not shown in Figure 2). The composition (C) as above detailed is particularly suitable for making basic housings and/or heatsink slugs as above described, because, besides having excellent thermal conductivity thus allowing the heat produced by the optoelectronic device to be easily dissipated, it has also good mechanical properties, high heat deflection temperature, good plateability, good adhesion to lead frame, excellent optical properties, notably excellent initial whiteness and high retention of reflectance, even after prolonged exposure to heat and radiation.

### Method of making the article

The article as above detailed can be manufactured processing the composition (C) as above detailed through standard techniques, including notably compression molding, extrusion molding, injection molding, or other melt-processing techniques.

It is nevertheless generally understood that the method of making the article, as above detailed, generally comprises a step of injection molding the composition (C), as detailed above.

The step of injection moulding generally uses a ram or screw-type plunger to force molten composition (C) into a mould cavity; within the cavity of the said mould, the composition (C) solidifies into a shape that has conformed to the contour of the mould.

Moulds which can be used can be single cavity moulds or multiple cavities moulds.

The invention will now be described in more details with reference to the following examples whose purpose is merely illustrative and not intended to limit the scope of the present invention.

### EXAMPLES

### Raw materials

Hyflon^{®} SBS91000850P MFA commercial powder grade, having a melting point of about 270°C, and a melt mass-flow rate (MFI) (372°C/5.0 kg) of 8.0 to 18.0 g/10 min [MFA-1, herein below)
Hyflon^{®} polymer based on TFE/PMVE/PPVE terpolymer (about 91.1/8/0.9 moles) having MFI of 500 g/10 min, and melting point of about 240°C (MFA-2, herein below)
Barium sulfate EMPROVE^{®} ESSENTIAL Ph Eur,BP,USP, available from Merck (BaSO₄, herein below)
Polymist^{®} F5A PTFE is a PTFE micropowder commercially available from Solvay Specialty Polymers Italy SpA, possessing a B.E.T. surface area of less than 4.0 m²/g, a D₅₀ of about 4.0 µm, a bulk density of about 400 g/l a melting point of about 325°C and a non-measurable MFI (372°C/10 kg) [µ-PTFE-1, herein after].
Algoflon^{®} L 2013 PTFE is a PTFE micropowder commercially available from Solvay Specialty Polymers Italy SpA, possessing a B.E.T. surface area of more than 7.5 m²/g, a D₅₀ of about 5.0 µm, a bulk density of about 330 g/l a melting point of about 329°C and a MFI (372°C/10 kg) of 1.2 g/10 min [µ-PTFE-2, herein after].

### Example 1C (of comparison)

The powders of MFA-1 were mixed in a turbo-mixer for 3' with BaSO₄ in a ratio 90/10 %w, then the powdered blend was pelletized in a Brabender conical twin screw extruder. The temperature profile was set in order to have a melt temperature in a range between 280°C and 320°C depending on the melt viscosity and the melting point of the polymer. Then the pellets underwent melt-compression moulding at 270-320°C in a vertical press in order to make a plaque with a thickness of about 1.5 mm. The reflectance of the sample was measured on the plaque at room temperature and results were summarized in Table A. MFI was determined on extruded pellets at 372°C under 5 kg as load .

### Example 2C (of comparison)

The procedures are the same described in Ex 1 except the ratio between BaSO₄ and MFA-1 was set to 80/20 %wt.

### Example 3C (of comparison)

The powders of MFA-1 were mixed in a turbo-mixer for 3' with BaSO₄ and µ-PTFE-1 in a ratio 75/20/5 %w, then the powdered blend composition was pelletized in a Brabender conical twin screw extruder. Otherwise, same procedure of Ex 1 was followed.

### Example 4 (according to the invention)

The procedures of compounding preparation and palletisation and compression moulding are the same described in Ex 3C but the formulation was based on MFA-1, BaSO₄ and µ-PTFE-2 in a ratio 75/25/5 %wt.

### Example 5 (according to the invention)

The procedures of compounding preparation and pelletization and compression moulding are the same described in Ex 4 except the ratio between the ingredients MFA-1, BaSO₄ and µ-PTFE-2 was 60/30/10 %wt.

### Example 6C (of comparison)

The procedures of compounding preparation and pelletization and compression moulding are the same described in Ex 4 except that no BaSO₄ was used and the ingredients MFA-1 and µ-PTFE-1 were used in a ratio 90/10%wt.

### Example 7C (of comparison)

The procedures of compounding preparation and pelletization and compression moulding are the same described in Ex 4 except that no BaSO₄ was used and the ingredients MFA-1 and µ-PTFE-1 were used in a ratio 90/10%wt.

### Example 8C (of comparison)

BaSO₄ was treated in oven at 120°C for 2 hrs under vacuum to have a drier, clearer filler and then compounded with the powders of MFA-2 in a ratio 80/20 %wt, and then mixed in a turbomixer for 3'. The powders composition was pelletized in a Brabender conical twin screw extruder and the temperature profile was set in order to have a melt temperature in a range between 280°C and 300°C depending on the melt viscosity and the melting point of the polymer. Then the pellets underwent melt-compression moulding at 270-320°C in a vertical press in order to make a plaque with a thickness of about 1.5 mm.

### Example 9 (according to the invention)

An amount of µ-PTFE-2 was added to ingredients of Ex. 8C so that the weight ration MFA-2/BaSO₄/µ-PTFE-2 was set to 70/20/10. Powders were blended in a turbo-mixer for 3' and then pelletized in order to have a melt temperature in a range between 280°C and 300°C and then the pellet underwent melt-compression moulding at 300°C as described above.

### Example 10C (of comparison)

The procedures of compounding preparation and pelletization and compression moulding are the same described in Ex 8 except that BaSO₄ was used as supplied, without thermal treatment.

### Reflectivity measurements

In tables below, reflectivity is intended to designate the % ratio of reflected radiant flux over incident radiant flux. A compression molded specimen was inserted in a UV-Vis spectrophotometer (Shimadzu 3600), equipped with halogen and xenon light sources that emit from UV to IR region, and the radiation reflected over the full solid angle was determined by means of an integrating sphere, i.e. a spherical cavity with a diameter of 15 cm, internally coated with a BaSO₄ layer, that absorbs all the impinging radiation via multiple reflections. Measurements were carried out according to ASTM E 903 standard (Standard Test Method for Solar Absorptance, Reflectance, and Transmittance of Materials Using Integrating Spheres).

**Table 1**

| Run | Ingredients | | | |
|---|---|---|---|---|
| | MFA-1 | BaSO₄ | µ-PTFE-1 | µ-PTFE-2 |
| | (%wt) | (%wt) | (%wt) | %w |
| Ref. | 100 | | | |
| 1C | 90 | 10 | | |
| 2C | 80 | 20 | | |
| 3C | 75 | 20 | 5 | |
| 4 | 75 | 20 | | 5 |
| 5 | 60 | 30 | | 10 |
| 6C | 90 | | 10 | |
| 7C | 90 | | | 10 |

**Table 2**

| Run | | Reflectivity^{*} | | | |
|---|---|---|---|---|---|
| | MFI^{**} | 280 nm | 315 nm | 380 nm | 405 nm |
| | g/10' | % | % | % | % |
| Ref. | 12 | | | | |
| 1C | | 69.4 | 69.7 | 72.4 | 73.7 |
| 2C | 10 | 71.1 | 72.9 | 76.6 | 78 |
| 3C | 10.4 | 71.6 | 71.9 | 74.5 | 75.6 |
| 4 | 9.5 | 76 | 76 | 78.8 | 79.8 |
| 5 | 4.6 | 79 | 79.5 | 82 | 83.1 |
| 6C | | 34.6 | 31.9 | 29 | 27.6 |
| 7C | | 47.6 | 41 | 33 | 30.4 |

| | | | | | |
|---|---|---|---|---|---|
| [0137] (*) measured on compression molded plaques having thickness of 1.5 mm; (**) MFI measures at 372°C under a piston load of 5 kg, according to ASTM D 1238 standard. | | | | | |

**Table 3**

| Run | Ingredients | | | |
|---|---|---|---|---|
| | MFA-2 | BaSO₄ | | µ-PTFE-2 |
| | (%wt) | (%wt) | (§) | (%wt) |
| | 100 | | | |
| 8C | 80 | 20 | TT | |
| 9 | 70 | 20 | TT | 10 |
| 10C | 80 | 20 | no TT | |

| | | | | |
|---|---|---|---|---|
| [0139] (§) "TT" means thermal treatment of BaSO₄ under vacuum for 2 hours at 120°C before mixing and compounding; "no TT" means no thermal treatment of BaSO₄ before mixing and compounding. | | | | |

**Table 4**

| Run | | Reflectivity* | | | | |
|---|---|---|---|---|---|---|
| | MFI** | 240 nm | 280 nm | 315 nm | 380 nm | 405 nm |
| | g/10' | % | % | % | % | % |
| | 500 | | | | | |
| 8C | 285 | 78.9 | 81.1 | 81.2 | 83.7 | 85.6 |
| 9 | 261 | 83.5 | 84.3 | 83.7 | 84.8 | 85.9 |
| 10C | | 74.7 | 76.7 | 78 | 80.6 | 82.2 |

| | | | | | | |
|---|---|---|---|---|---|---|
| [0140] (*) measured on compression molded plaques having thickness of 1.5 mm; (**) MFI measures at 372°C under a piston load of 5 kg, according to ASTM D 1238 standard. | | | | | | |

**Table 5**

| Run | WI* | Stensby** | YI*** |
|---|---|---|---|
| Ex 2C | 72 | 86 | 7 |
| Ex 8C | 73 | 88 | 6 |
| Ex 9 | 76 | 89 | 5 |

All colour characteristics determined on compression molded plaques having a thickness of 1.5 mm. *WI: White index determined according to

ASTM E313-00 standard, using a D65 illuminant/10° geometry , using K Color View Instrument; **Stensby: Stensby Whiteness Index, determined according to E313-00 standard; ***YI: Yellow index determined according to ASTM E313-00 standard, using a D65 illuminant/10° geometry , using K Color View Instrument

## Claims

1. A fluoropolymer composition [composition (C)] comprising:
(i) at least 50% by weight, with respect to the total weight of the composition (C) of at least one melt-processible perfluorinated tetrafluoroethylene copolymer [polymer (F)],
(ii) from 1 to less than 45 % wt., with respect to the total weight of the composition (C) of at least one pigment selected from the group consisting of titanium dioxide (TiO₂), zinc disulfide (ZnS₂), zinc oxide (ZnO) and barium sulfate (BaSO₄) [pigment (P)];
(iii) from 0.5 to 20 % wt., with respect to the total weight of the composition (C) of at least one PTFE micropowder possessing a B.E.T. surface area, determined according to the method described in the specification, exceeding 5.0 m²/g [powder (PTFE)]; and optionally,
(iii) at least one reinforcing filler [filler (F)], different from pigment (P).

2. The composition (C) of Claim 1, wherein polymer (F) is selected from the group consisting of TFE copolymers comprising recurring units derived from hexafluoropropylene (HFP) and from at least one CF₂=CFOR_{f} perfluoroalkylvinylether (PAVE), wherein R_{f} is a C₁-C₆ perfluoroalkyl.

3. The composition (C) of Claim 1, wherein the polymer (F) is selected from the group consisting of TFE copolymers comprising recurring units derived from at least one at least one CF₂=CFOR_{f} perfluoroalkylvinylether (PAVE), wherein R_{f} is a C₁-C₆ perfluoroalkyl, and optionally further comprising recurring units derived from at least one C₃-C₈ perfluoroolefin.

4. The composition (C) of Claim 3, wherein polymer (F) is a TFE/PMVE copolymer consisting essentially of :
(a) from 3 to 13 %, preferably from 5 to 12 % by weight of recurring units derived from perfluoromethylvinylether;
(b)from 0 to 6 % by weight of recurring units derived from one or more than one fluorinated comonomer different from perfluoromethylvinylether and selected from the group consisting of perfluoroalkylvinylethers as detailed above, and perfluorooxyalkylvinylethers as detailed above; preferably derived from perfluoroethylvinylether and/or perfluoropropylvinylether ;
(c) recurring units derived from tetrafluoroethylene, in such an amount that the sum of the percentages of the recurring units (a), (b) and (c) is equal to 100 % by weight.

5. The composition (C) of Claim 3, wherein the polymer (F) is a TFE copolymer consisting essentially of :
(a)from 0.5 to 5 % by weight of recurring units derived from perfluoromethylvinylether;
(b)from 0.4 to 4.5 % by weight of recurring units derived from one or more than one fluorinated comonomer different from perfluoromethylvinylether and selected from the group consisting of perfluoroalkylvinylethers, as above detailed and perfluorooxyalkylvinylethers, as above detailed; preferably derived from perfluoroethylvinylether and/or perfluoropropylvinylether ;
(c) from 0 to 6 % weight of recurring units derived from at least one C₃-C₈ perfluoroolefins, preferably derived from hexafluoropropylene; and
(d) recurring units derived from tetrafluoroethylene, in such an amount that the sum of the percentages of the recurring units (a), (b), (c) and (d) is equal to 100 % by weight.

6. The composition (C) of Claim 3, wherein the polymer (F) is a TFE copolymer consisting essentially of:
(a)from 0.5 to 8 %, preferably from 0.7 to 6 % by weight of recurring units derived from perfluoropropylvinylether (PPVE);
(b) recurring units derived from TFE, in such an amount that the sum of the percentages of the recurring units (a) and (b) is equal to 100 % by weight.

7. The composition (C) of anyone of the preceding claims wherein pigment (P) is Barium sulfate (BaSO₄).

8. The composition (C) of anyone of the preceding claims, wherein the weight percent of the pigment (P) in the composition (C) is of at least 3 wt. %, more preferably of at least 5 wt. % and most preferably of at least 6 wt. %, based on the total weight of the composition (C) and/or is of at most 45 wt. %, more preferably of at most 30 wt. %, even more preferably of at most 25 wt. % and most preferably of at most 20 wt. %, based on the total weight of the composition (C).

9. The composition (C) of anyone of the preceding claims, wherein the powder (PTFE) possesses a B.E.T. surface area, determined according to the method described in the specification, exceeding 6.0 m²/g, more preferablyefexceeding 7.0 m²/g, and/or possesses a bulk density, measured according to ASTM D 4895 standard, referring back to ASTM D1895, of less than 380, preferably less than 350, more preferably less than 340 g/l.

10. The composition (C) of anyone of the preceding claims, wherein the weight percent of the powder (PTFE) in the composition (C) is of at least 1 wt. %, preferably of at least 3 wt. %, more preferably of at least 5 wt. %, based on the total weight of the composition (C), and/or is of at most 18 wt. %, preferably of at most 17 wt. %, more preferably of at most 16 wt. % and most preferably of at most 15 wt. %, based on the total weight of the composition (C).

11. An article comprising at least one component comprising the fluoropolymer composition (C) according to anyone of claims 1 to 10.

12. The article of claim 11, said article being a light emission apparatus selected from the group consisting of keyless entry systems of an automobile, lightings in a refrigerator, liquid crystal display apparatuses, automobile front panel lighting apparatuses, desk lamps, headlights, household electrical appliance indicators and outdoor display apparatuses, and optoelectronic devices comprising at least one semi-conductor chip that emits and/or transmits electromagnetic radiation commonly known as Light Emitting Diodes devices (LEDs).

13. The article of Claim 12, which is a Light Emitting Diode device possessing junctions emitting in the UV region.

14. A method for making the article of anyone of Claims 11 to 13, the method comprising processing the composition (C) of anyone of Claims 1 to 10 through standard techniques, including notably compression molding, extrusion molding, injection molding, or other melt-processing techniques.

15. The method of making of claim 14, said method comprising a step of injection molding the composition (C).

16. The method of making of claim 15, wherein the step of injection moulding uses a ram or screw-type plunger to force molten composition (C) into a mould cavity; and wherein within the cavity of the said mould, the composition (C) solidifies into a shape that has conformed to the contour of the mould.

## Patentansprüche

1. Fluorpolymerzusammensetzung [Zusammensetzung (C)], umfassend:
(i) zu mindestens 50 Gew.-%, bezogen auf das Gesamtgewicht der Zusammensetzung (C), mindestens ein schmelzverarbeitbares perfluoriertes Tetrafluorethylencopolymer [Polymer (F)],
(ii) zu 1 bis weniger als 45 Gew.-%, bezogen auf das Gesamtgewicht der Zusammensetzung (C), mindestens ein Pigment, das ausgewählt ist aus der Gruppe bestehend aus Titandioxid (TiO₂), Zinkdisulfid (ZnS₂), Zinkoxid (ZnO) und Bariumsulfat (BaSO₄) [Pigment (P)];
(iii) zu 0,5 bis 20 Gew.-%, bezogen auf das Gesamtgewicht der Zusammensetzung (C), mindestens ein PTFE-Mikropulver, das bei Bestimmung gemäß dem in der Beschreibung beschriebenen Verfahren eine BET-Oberfläche von über 5,0 m²/g besitzt [Pulver (PTFE)]; und gegebenenfalls,
(iii) mindestens einen Verstärkerfüllstoff [Füllstoff (F)], der von dem Pigment (P) verschieden ist.

2. Zusammensetzung (C) nach Anspruch 1, wobei das Polymer (F) ausgewählt ist aus der Gruppe bestehend aus TFE-Copolymeren, die wiederkehrende Einheiten umfassen, die von Hexafluorpropylen (HFP) und von mindestens einem CF₂=CFOR_{f}-Perfluoralkylvinylether (PAVE) abgeleitet sind, wobei R_{f} für ein C₁-C₆-Perfluoralkyl steht.

3. Zusammensetzung (C) nach Anspruch 1, wobei das Polymer (F) ausgewählt ist aus der Gruppe bestehend aus TFE-Copolymeren, die wiederkehrende Einheiten umfassen, die von mindestens einem CF₂=CFOR_{f}-Perfluoralkylvinylether (PAVE) abgeleitet sind, wobei R_{f} für ein C₁-C₆-Perfluoralkyl steht, und gegebenenfalls ferner umfassend wiederkehrende Einheiten, die von mindestens einem C₃-C₈-Perfluorolefin abgeleitet sind.

4. Zusammensetzung (C) nach Anspruch 3, wobei es sich bei dem Polymer (F) um ein TFE/PMVE-Copolymer handelt, das im Wesentlichen aus Folgendem besteht:
(a) zu 3 bis 13 Gew.-%, vorzugsweise zu 5 bis 12 Gew.-% wiederkehrende Einheiten, die von Perfluormethylvinylether abgeleitet sind;
(b) zu 0 bis 6 Gew.-% wiederkehrende Einheiten, die von einem oder mehr als einem fluorierten Comonomer abgeleitet sind, das von Perfluormethylvinylether verschieden ist und ausgewählt ist aus der Gruppe bestehend aus Perfluoralkylvinylethern, wie vorstehend ausgeführt, und Perfluoroxyalkylvinylethern, wie vorstehend ausgeführt; vorzugsweise abgeleitet von Perfluorethylvinylether und/oder Perfluorpropylvinylether;
(c) wiederkehrende Einheiten, die von Tetrafluorethylen abgeleitet sind, in einer solchen Menge, dass die Summe der Prozentsätze der wiederkehrenden Einheiten (a), (b) und (c) gleich 100 Gew.-% ist.

5. Zusammensetzung (C) nach Anspruch 3, wobei es sich bei dem Polymer (F) um ein TFE-Copolymer handelt, das im Wesentlichen aus Folgendem besteht:
(a) zu 0,5 bis 5 Gew.-% wiederkehrende Einheiten, die von Perfluormethylvinylether abgeleitet sind;
(b) zu 0,4 bis 4,5 Gew.-% wiederkehrende Einheiten, die von einem oder mehr als einem fluorierten Comonomer abgeleitet sind, das von Perfluormethylvinylether verschieden ist und ausgewählt ist aus der Gruppe bestehend aus Perfluoralkylvinylethern, wie vorstehend ausgeführt, und Perfluoroxyalkylvinylethern, wie vorstehend ausgeführt; vorzugsweise abgeleitet von Perfluorethylvinylether und/oder Perfluorpropylvinylether;
(c) zu 0 bis 6 Gew.-% wiederkehrende Einheiten, die von mindestens einem C₃-C₈-Perfluorolefin abgeleitet sind, vorzugsweise abgeleitet von Hexafluorpropylen; und
(d) wiederkehrende Einheiten, die von Tetrafluorethylen abgeleitet sind, in einer solchen Menge, dass die Summe der Prozentsätze der wiederkehrenden Einheiten (a), (b), (c) und (d) gleich 100 Gew.-% ist.

6. Zusammensetzung (C) nach Anspruch 3, wobei es sich bei dem Polymer (F) um ein TFE-Copolymer handelt, das im Wesentlichen aus Folgendem besteht:
(a) zu 0,5 bis 8 %, vorzugsweise zu 0,7 bis 6 Gew.-% wiederkehrende Einheiten, die von Perfluorpropylvinylether (PPVE) abgeleitet sind;
(b) wiederkehrende Einheiten, die von TFE abgeleitet sind, in einer solchen Menge, dass die Summe der Prozentsätze der wiederkehrende Einheiten (a) und (b) gleich 100 Gew.-% ist.

7. Zusammensetzung (C) nach einem der vorstehenden Ansprüche, wobei es sich bei dem Pigment (P) um Bariumsulfat (BaSO₄) handelt.

8. Zusammensetzung (C) nach einem der vorstehenden Ansprüche, wobei der Gewichtsprozentsatz des Pigments (P) in der Zusammensetzung (C) mindestens 3 Gew.-% beträgt, besonders bevorzugt mindestens 5 Gew.-% und ganz besonders bevorzugt mindestens 6 Gew.-%, bezogen auf das Gesamtgewicht der Zusammensetzung (C), und/oder höchstens 45 Gew.-% beträgt, besonders bevorzugt höchstens 30 Gew.-%, besonders bevorzugt höchstens 25 Gew.-% und ganz besonders bevorzugt höchstens 20 Gew.-%, bezogen auf das Gesamtgewicht der Zusammensetzung (C).

9. Zusammensetzung (C) nach einem der vorstehenden Ansprüche, wobei das Pulver (PTFE) bei Bestimmung gemäß dem in der Beschreibung beschriebenen Verfahren eine BET-Oberfläche von über 6,0 m²/g besitzt, besonders bevorzugt von über 7,0 m²/g, und/oder bei Messung gemäß der Norm ASTM D 4895, die sich auf ASTM D1895 zurückbezieht, eine Schüttdichte von weniger als 380, vorzugsweise weniger als 350, besonders bevorzugt weniger als 340 g/l besitzt.

10. Zusammensetzung (C) nach einem der vorstehenden Ansprüche, wobei der Gewichtsprozentsatz des Pulvers (PTFE) in der Zusammensetzung (C) mindestens 1 Gew.-%, vorzugsweise mindestens 3 Gew.-%, besonders bevorzugt mindestens 5 Gew.-%, bezogen auf das Gesamtgewicht der Zusammensetzung (C), beträgt und/oder höchstens 18 Gew.-%, vorzugsweise höchstens 17 Gew.-%, besonders bevorzugt höchstens 16 Gew.-% und ganz besonders bevorzugt höchstens 15 Gew.-%, bezogen auf das Gesamtgewicht der Zusammensetzung (C), beträgt.

11. Erzeugnis, umfassend mindestens eine Komponente, die die Fluorpolymer-Zusammensetzung (C) nach einem der Ansprüche 1 bis 10 umfasst.

12. Erzeugnis nach Anspruch 11, wobei es sich bei dem Erzeugnis um eine Licht emittierende Vorrichtung handelt, die ausgewählt ist aus der Gruppe bestehend aus schlüssellosen Zugangssystemen eines Kraftfahrzeugs, Beleuchtungen in einem Kühlschrank, Flüssigkristallanzeigevorrichtungen, Kraftfahrzeugfrontscheibenbeleuchtungsvorrichtungen, Schreibtischlampen, Scheinwerfern, Haushaltselektrogeräteanzeigen und Außenanzeigevorrichtungen sowie optoelektronischen Einrichtungen, die mindestens einen Halbleiterchip umfassen, der elektromagnetische Strahlung emittiert und/oder transmittiert, und allgemein als Leuchtdiodeneinrichtungen (LED-Einrichtungen) bekannt sind.

13. Erzeugnis nach Anspruch 12, bei dem es sich um eine Leuchtdiodeneinrichtung handelt, die im UV-Bereich emittierende Sperrschichten besitzt.

14. Verfahren zum Herstellen des Erzeugnisses nach einem der Ansprüche 11 bis 13, wobei das Verfahren das Verarbeiten der Zusammensetzung (C) nach einem der Ansprüche 1 bis 10 durch Standardtechniken, einschließlich insbesondere Formpressen, Strangpressen, Spritzgießen oder sonstiger Schmelzverarbeitungstechniken, umfasst.

15. Verfahren zum Herstellen nach Anspruch 14, wobei das Verfahren einen Schritt des Spritzgießens der Zusammensetzung (C) umfasst.

16. Verfahren zum Herstellen nach Anspruch 15, wobei im Schritt des Spritzgießens ein stößel- oder schraubenartiger Kolben verwendet wird, um geschmolzene Zusammensetzung (C) in einen Formhohlraum zu drängen; und wobei die Zusammensetzung (C) in dem Hohlraum der Form zu einer Gestalt erstarrt, die der Kontur der Form entspricht.

## Revendications

1. Composition de fluoropolymère [composition (C)] comprenant :
(i) au moins 50 % en poids, par rapport au poids total de la composition (C) d'au moins un copolymère de tétrafluoroéthylène perfluoré pouvant être traité par fusion [polymère (F)],
(ii) de 1 à moins de 45 % en poids, par rapport au poids total de la composition (C) d'au moins un pigment choisi dans le groupe constitué par le dioxyde de titane (TiO₂), le disulfure de zinc (ZnS₂), l'oxyde de zinc (ZnO) et le sulfate de baryum (BaSO₄) [pigment (P)] ;
(iii) de 0,5 à 20 % en poids, par rapport au poids total de la composition (C) d'au moins une micropoudre de PTFE possédant une superficie B.E.T., déterminée selon le procédé décrit dans ladite description, excédant 5,0 m²/g [poudre (PTFE)] ; et éventuellement,
(iii) au moins une charge de renforcement [charge (F)], différente du pigment (P).

2. Composition (C) selon la revendication 1, le polymère (F) étant choisi dans le groupe constitué par des copolymères de TFE comprenant des motifs répétitifs issus de l'hexafluoropropylène (HFP) et d'au moins un perfluoroalkylvinyléther CF₂=CFOR_{f} (PAVE), R_{f} étant un C₁₋₆ perfluoroalkyle.

3. Composition (C) selon la revendication 1, le polymère (F) étant choisi dans le groupe constitué par des copolymères de TFE comprenant des motifs répétitifs issus d'au moins un perfluoroalkylvinyléther CF₂=CFOR_{f} (PAVE), R_{f} étant un C₁₋₆ perfluoroalkyle, et comprenant éventuellement en outre des motifs répétitifs issus d'au moins une C₃₋₈ perfluorooléfine.

4. Composition (C) selon la revendication 3, le polymère (F) étant un copolymère de TFE/PMVE constitué essentiellement :
(a) de 3 à 13 %, préférablement de 5 à 12 % en poids de motifs répétitifs issus de perfluorométhylvinyléther ;
(b) de 0 à 6 % en poids de motifs répétitifs issus d'un ou de plus d'un comonomère fluoré différent de perfluorométhylvinyléther et choisi dans le groupe constitué par des perfluoroalkylvinyléthers tels que détaillés ci-dessus, et des per fluorooxyalkylvinyléthers comme détaillés ci-dessus ; préférablement issus de perfluoroéthylvinyléther et/ou de perfluoropropylvinyléther ;
(c) de motifs répétitifs issus du tétrafluoroéthylène, en une telle quantité que la somme des pourcentages des motifs répétitifs (a), (b) et (c) soit égale à 100 % en poids.

5. Composition (C) selon la revendication 3, le polymère (F) étant un copolymère de TFE constitué essentiellement :
(a) de 0,5 à 5 % en poids de motifs répétitifs issus de perfluorométhylvinyléther ;
(b) de 0,4 à 4,5 % en poids de motifs répétitifs issus d'un ou de plus d'un comonomère fluoré différent de perfluorométhylvinyléther et choisi dans le groupe constitué par des perfluoroalkylvinyléthers tels que détaillés ci-dessus, et des per fluorooxyalkylvinyléthers comme détaillés ci-dessus ; préférablement issus de perfluoroéthylvinyléther et/ou de perfluoropropylvinyléther ;
(c) de 0 à 6 % poids de motifs répétitifs issus d'au moins une C₃₋₈ perfluorooléfine, préférablement issus de l'hexafluoropropylène ; et
(d) de motifs répétitifs issus du tétrafluoroéthylène, en une telle quantité que la somme des pourcentages des motifs répétitifs (a), (b), (c) et (d) soit égale à 100 % en poids.

6. Composition (C) selon la revendication 3, le polymère (F) étant un copolymère de TFE constitué essentiellement :
(a) de 0,5 à 8 %, préférablement de 0,7 à 6 % en poids de motifs répétitifs issus de perfluoropropylvinyléther (PPVE) ;
(b) de motifs répétitifs issus de TFE, en une telle quantité que la somme des pourcentages des motifs répétitifs (a) et (b) soit égale à 100 % en poids.

7. Composition (C) selon l'une quelconque des revendications précédentes, le pigment (P) étant le sulfate de baryum (BaSO₄).

8. Composition (C) selon l'une quelconque des revendications précédentes, le pourcentage en poids du pigment (P) dans la composition (C) étant d'au moins 3 % en poids, plus préférablement d'au moins 5 % en poids et le plus préférablement d'au moins 6 % en poids, sur la base du poids total de la composition (C) et/ou étant d'au plus 45 % en poids, plus préférablement d'au plus 30 % en poids, encore plus préférablement d'au plus 25 % en poids et le plus préférablement d'au plus 20 % en poids, sur la base du poids total de la composition (C).

9. Composition (C) selon l'une quelconque des revendications précédentes, la poudre (PTFE) possédant une superficie B.E.T., déterminée selon le procédé décrit dans ladite description, excédant 6,0 m²/g, plus préférablement excédant 7,0 m²/g, et/ou possédant une densité apparente, mesurée selon la norme ASTM D 4895, qui fait référence à la norme ASTM D1895, inférieure à 380, préférablement inférieure à 350, plus préférablement inférieure à 340 g/l.

10. Composition (C) selon l'une quelconque des revendications précédentes, le pourcentage en poids de la poudre (PTFE) dans la composition (C) étant d'au moins 1 % en poids, préférablement d'au moins 3 % en poids, plus préférablement d'au moins 5 % en poids, sur la base du poids total de la composition (C), et/ou étant d'au plus 18 % en poids, préférablement d'au plus 17 % en poids, plus préférablement d'au plus 16 % en poids et le plus préférablement d'au plus 15 % en poids, sur la base du poids total de la composition (C).

11. Article comprenant au moins un composant comprenant la composition de fluoropolymère (C) selon l'une quelconque des revendications 1 à 10.

12. Article selon la revendication 11, ledit article étant un appareil d'émission de lumière choisi dans le groupe constitué par des systèmes d'entrée sans clé d'une automobile, des éclairages dans un réfrigérateur, des appareils d'affichage à cristaux liquides, des appareils d'éclairage pour panneau avant automobile, des lampes de bureau, des lampes frontales, des indicateurs d'appareils électriques ménagers et des appareils d'affichage à l'extérieur, et des dispositifs optoélectroniques comprenant au moins une puce semi-conductrice qui émet et/ou transmet un rayonnement électromagnétique communément appelés dispositifs à Diode Luminescente (LED).

13. Article selon la revendication 12, qui est un dispositif à Diode Luminescente possédant des jonctions émettant dans le domaine des UV.

14. Procédé pour la fabrication de l'article selon l'une quelconque des revendications 11 à 13, le procédé comprenant le traitement de la composition (C) selon l'une quelconque des revendications 1 à 10 par l'intermédiaire de techniques standard, y compris notamment le moulage par compression, le moulage par extrusion, le moulage par injection ou d'autres techniques de traitement de masse fondue.

15. Procédé de fabrication selon la revendication 14, ledit procédé comprenant une étape de moulage par injection de la composition (C).

16. Procédé de fabrication selon la revendication 15, l'étape de moulage par injection utilisant un piston plongeur ou de type vis pour forcer la composition (C) fondue dans une cavité de moule ; et, à l'intérieur de la cavité dudit moule, la composition (C) se solidifie en une forme qui s'est conformée aux contours du moule.
